# EUROPÄISCHE PATENTSCHRIFT

(11) **EP 1 163 678 B1**
(45) Veröffentlichungstag und Bekanntmachung des Hinweises auf die Patenterteilung: **29.01.2003**
(21) Anmeldenummer: 00926687.5
(22) Anmeldetag: 24.03.2000
(51) Int. Cl.: G11C 11/22

(54) **INTEGRIERTER SPEICHER MIT SPEICHERZELLEN, DIE JE EINEN FERROELEKTRISCHEN SPEICHERTRANSISTOR AUFWEISEN**
INTEGRATED MEMORY WITH MEMORY CELLS WHICH EACH HAVE A FERROELECTRIC MEMORY TRANSISTOR
MEMOIRE INTEGREE AVEC CELLULES MEMOIRES PRESENTANT CHACUNE UN TRANSISTOR MEMOIRE FERROELECTRIQUE

(30) Priorität: 25.03.1999 DE 19913571
(43) Veröffentlichungstag der Anmeldung: 19.12.2001
(73) Patentinhaber: Infineon Technologies AG, 81669 München (DE)
(72) Erfinder: HÖNIGSCHMID, Heinz, D-82319 Starnberg (DE); ULLMANN, Marc, D-22085 Hamburg (DE)
(74) Vertreter: Kottmann, Heinz Dieter, Dipl.-Ing.
(86) Internationale Anmeldenummer: DE0000901
(87) Internationale Veröffentlichungsnummer: WO00058971

(56) Entgegenhaltungen:
- EP-A- 0 459 572
- EP-A- 0 827 153
- WO-A-99/19878
- US-A- 5 541 871
- US-A- 5 563 081

## Beschreibung

Die Erfindung betrifft einen integrierten Speicher mit Speicherzellen, die je einen ferroelektrischen Speichertransistor aufweisen.

In der US 5,541,871 A ist ein ferroelektrischer HalbleiterSpeicher beschrieben, dessen Speicherzellen aus je einem ferroelektrischen Speichertransistor bestehen. Ferroelektrische Transistoren weisen ein ferroelektrisches Gatedielektrikum auf. Durch Beaufschlagung eines Spannungspulses an der Steuerelektrode des Transistors wird die Richtung der Polarisation des Ferroelektrikums und somit die Schwellenspannung des Transistors eingestellt. Bei einer vorgegebenen Drain-Source-Spannung des Transistors ergibt sich in Abhängigkeit der Schwellenspannung des Transistors ein unterschiedlicher Drainstrom.

Für das Auslesen der Speichertransistoren wird in der US 5,541,871 A an den Transistor eine vorgegebene Drain-Source-Spannung angelegt und das Gate des Transistors auf ein Potential gebracht, durch welches der Transistor leitend geschalten wird. Anschließend wird der sich einstellende Source-Drain-Strom erfaßt. Wird ein niedriger Drainstrom detektiert, handelt es sich um einen ersten Polarisationszustand des ferroelektrischen Dielektrikums der Transistorgateelektrode. Wird ein großer Drainstrom detektiert, handelt es sich um einen zweiten Polarisationszustand des Ferroelektrikums. Auf diese Weise werden zwei unterschiedliche vom Transistor gespeicherte logische Zustände unterschieden.

In der US 5,541,871 A sind die Speicherzellen, die durch die ferroelektrischen Speichertransistoren gebildet sind, matrixförmig angeordnet. Ihre Sourceanschlüsse sind mit in einer ersten Richtung verlaufenden parallelen Sourceleitungen verbunden. Ihre Drainanschlüsse sind mit in einer zur ersten Richtung senkrechten zweiten Richtung verlaufenden, parallelen Drainleitungen verbunden. Ihre Gates bzw. Steuerelektroden sind mit in der zweiten Richtung verlaufenden Steuerleitungen verbunden, die die Funktion von Wortleitungen haben. Da die Sourceleitungen und die Drainleitungen senkrecht zueinander verlaufen, ist es notwendig, um Kurzschlüsse zu vermeiden, daß sie zumindest im Bereich ihrer Überkreuzung in unterschiedlichen Verdrahtungsebenen des Speichers verlaufen. Die Drainanschlüsse und die Sourceanschlüsse der Transistoren, mit denen diese Leitungen verbunden sind, sind in einem Substrat des Speichers und somit in einer gemeinsamen Verdrahtungsebene angeordnet.

Der Erfindung liegt die Aufgabe zugrunde, einen integrierten Speicher mit Speicherzellen anzugeben, die je einen ferroelektrischen Speichertransistor aufweisen, dessen Herstellung gegenüber dem oben angegebenen Stand der Technik vereinfacht ist.

Diese Aufgabe wird mit einem integrierten Speicher gemäß Patentanspruch 1 gelöst. Vorteilhafte Aus- und Weiterbildungen der Erfindung sind Gegenstand der abhängigen Patentansprüche.

Der erfindungsgemäße integrierte Speicher weist in einer ersten Richtung verlaufende Wortleitungen sowie in einer zweiten Richtung, die senkrecht zur ersten Richtung ist, verlaufende Bitleitungen und Steuerleitungen auf. Eine steuerbare Strecke jedes Speichertransistors verbindet jeweils eine der Bitleitungen mit einer der Steuerleitungen. Die Steuerelektrode jedes Speichertransistors ist mit einer der Wortleitungen verbunden.

Da die Bitleitungen und Steuerleitungen in dieselbe Richtung verlaufen und somit parallel zueinander angeordnet sind, können sie innerhalb einer gemeinsamen Verdrahtungsebene des integrierten Speichers angeordnet sein. Da die Anschlüsse der steuerbaren Strecke (bei einem MOS-Transistor sind dies die Drain-/Source-Gebiete) üblicherweise ebenfalls in einer gemeinsamen Verdrahtungsebene, beispielsweise in einem Substrat des integrierten Speichers, angeordnet sind, können beim erfindungsgemäßen integrierten Speicher die Bitleitungen und Steuerleitungen in derselben Verdrahtungsebene angeordnet sein, wie die steuerbare Strecke der Transistoren. Somit ergibt sich ein platzsparender, einfacher Aufbau des Speichers. Um eine Verbindung zwischen den Bitleitungen bzw. Steuerleitungen und den zugehörigen Anschlüssen der zu steuernden Strecken der Transistoren herzustellen, sind keine Durchkontaktierungen notwendig, die verschiedene Verdrahtungsebenen des Speichers miteinander verbinden. Außerdem ergibt sich durch parallele Anordnung der Bitleitungen und Steuerleitungen eine sehr regelmäßige Anordnung der Speicherzellenmatrix.

Ein Betrieb des integrierten Speichers kann durchgeführt werden, indem eine vorgegebene Spannung an der steuerbaren Strecke eines der Speichertransistoren angelegt wird und die mit diesem Transistor verbundene Wortleitung aktiviert wird. Anschließend wird der sich ergebende Strom, der zwischen der betreffenden Steuerleitung und der zuhörigen Bitleitung fließt, erfaßt.

Nach der Erfindung ist jeweils eine der Steuerleitungen zwischen je zweien der Bitleitungen angeordnet, mit denen sie jeweils über die steuerbaren Strecken mehrerer der Speichertransistoren verbunden ist. Dies ermöglicht einen äußerst kompakten Aufbau des Speichers. Bei diesem kann ein Auslesen eines der Speichertransistoren erfolgen, indem zwischen einer der Steuerleitungen und den beiden zugehörigen Bitleitungen eine vorgegebene Spannung angelegt wird, eine der Wortleitungen aktiviert wird, so daß zwei der mit dieser Wortleitung und der betreffenden Steuerleitung verbundenen Speichertransistoren ausgewählt: werden und der jeweilige Strom über diese beiden Transistoren erfaßt wird.

Nach der Erfindung sind die steuerbaren Strecken der Speichertransistoren parallel zu den Bitleitungen und Steuerleitungen angeordnet, das heißt, auch sie verlaufen in der zweiten Richtung. Weiterhin weisen diejenigen Speichertransistoren, die mit derselben Bitleitung verbunden sind, jeweils gemeinsame Source-Drain-Gebiete auf. Hierdurch wird der Platzbedarf des integrierten Speichers weiter reduziert. Durch die parallele Anordnung der Bitleitungen und Steuerleitungen können in der zweiten Richtung die steuerbaren Strecken einer beliebigen Anzahl benachbarter Speichertransistoren miteinander verbunden sein.

Nach einer Weiterbildung der Erfindung weist der integrierte Speicher Stromerfassungseinheiten auf, die mit je einer der Bitleitungen verbunden sind, zur Erfassung eines während eines Lesezugriffs zwischen den Steuerleitungen und den Bitleitungen über die Speichertransistoren fließenden Stromes. Dadurch, daß auf diese Weise jeder Bitleitung eine Stromerfassungseinheit zugeordnet ist, kann bei einem Lesezugriff auf jeder der Bitleitungen jeweils eine der Speicherzellen ausgelesen werden.

Nach einer alternativen Weiterbildung der Erfindung weist der integrierte Speicher wenigstens zwei Multiplexer und zwei Stromerfassungseinheiten auf. Zwei der Bitleitungen, die über ihre Speichertransistoren mit zwei unterschiedlichen Steuerleitungen verbunden sind, sind über den ersten Multiplexer mit der ersten Stromerfassungseinheit verbunden. Zwei andere der Bitleitungen, die über ihre Speichertransistoren mit denselben beiden Steuerleitungen verbunden sind, wie die ersten beiden Bitleitungen, sind über den zweiten Multiplexer mit der zweiten Stromerfassungseinheit verbunden. Die Multiplexer haben zwei Betriebzustände, in denen sie jeweils eine der mit ihnen verbundenen Bitleitungen mit der jeweiligen Stromerfassungseinheit verbinden.

Bei dieser Weiterbildung sind also jeweils zwei Bitleitungen einer gemeinsamen Stromerfassungseinheit zugeordnet. Bei einem Lesezugriff erfolgt über die Multiplexer eine Auswahl, welche dieser beiden Bitleitungen jeweils durch die Stromerfassungseinheit ausgewertet werden soll. Somit kann die Anzahl der Stromerfassungseinheiten reduziert werden.

Im folgenden werden in den Figuren dargestellte Ausführungsbeispiele der Erfindung erläutert. Es zeigen:
- Figur 1: einen Speicher, bei dem jeweils eine Steuerleitung einer Bitleitung zugeordnet ist,
- Figur 2: ein erstes Ausführungsbeispiel des erfindungsgemäßen Speichers, bei dem jeweils einer Steuerleitung zwei Bitleitungen zugeordnet sind,
- Figur 3: ein Ausführungsbeispiel, bei dem jeder Bitleitung eine Stromerfassungseinheit zugeordnet ist, und
- Figur 4: ein Ausführungsbeispiel, bei dem jeweils zwei Bitleitungen eine gemeinsame Stromerfassungseinheit zugeordnet ist.

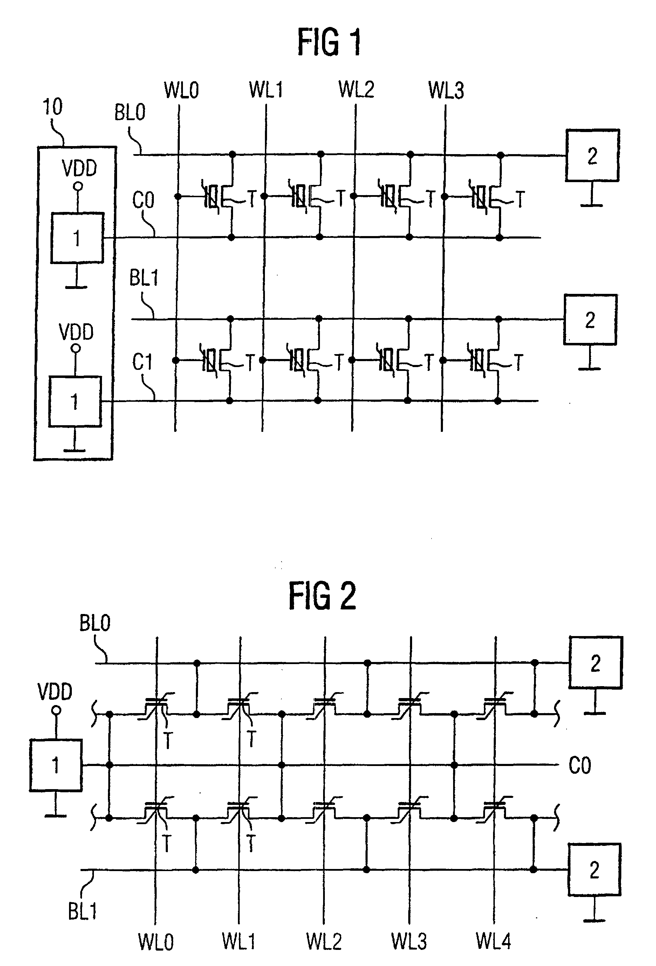

Der in Figur 1 dargestellte integrierte Speicher ist aus der EP 0 827 153 A (Fig. 5) bekannt und weist parallel zueinander angeordnete Wortleitungen WLi sowie senkrecht dazu angeordnete Bitleitungen BLi und Steuerleitungen Ci auf. Die Bitleitungen und Steuerleitungen sind alternierend angeordnet und weisen zueinander regelmäßige Abstände auf. In Kreuzungspunkten der Wortleitungen WLi, der Bitleitungen BLi und der Steuerleitungen Ci sind Speicherzellen in Form von ferroelektrischen Speichertransistoren T angeordnet. Diese verbinden die zugehörige Bitleitung BLi mit der zugehörigen Steuerleitung Ci über ihre steuerbaren Strecken. Steueranschlüsse der Speichertransistoren T sind mit der zugehörigen Wortleitung WLi verbunden. Obwohl in Figur 1 lediglich vier Wortleitungen WLi sowie jeweils zwei Bitleitungen BLi und Steuerleitungen Ci gezeigt sind, weist der Speicher in Wirklichkeit eine weitaus größere Zahl dieser Leitungen auf, so daß sich insgesamt ein weitaus größeres Speicherzellenfeld ergibt.

Die ferroelektrischen Speichertransistoren T weisen ein ferroelektrisches Gatedielektrikum auf, das durch Spannungspulse auf der mit ihnen verbundenen Wortleitung WLi zwei unterschiedliche Polarisationszustände annehmen kann. Auf diese Weise werden zwei unterschiedliche logische Informationen gespeichert. Eine Auswertung dieser Information erfolgt durch Messen eines während eines Lesezugriffs auf die Speicherzellen über die Kanalstrecken der Transistoren T fließenden Stromes.

Beim Speicher in Figur 1 ist jede der Steuerleitungen Ci mit dem Ausgang eines Potentialgenerators 1 verbunden, der bei einem Lesezugriff auf die Speicherzellen ein konstantes Lesepotential VDD liefert. Wie in Figur 1 angedeutet, kann statt separater Potentialgeneratoren 1 für jede Steuerleitung Ci ein gemeinsamer Potentialgenerator 10 vorgesehen sein, dessen Ausgangspotential allen Steuerleitungen Ci zugeführt wird.

In Figur 1 ist jede Bitleitung BLi mit einer Stromerfassungseinheit 2 verbunden. Diese können beispielsweise einen ohmschen Widerstand aufweisen, an dem eine dem durch ihn hindurchfließenden Strom proportionale Spannung abfällt, die als Maß für den Strom einer Auswertung zugeführt wird.

Ein Lesezugriff auf den in Figur 1 dargestellten Speicher erfolgt folgendermaßen:

Vor dem Lesezugriff befinden sich die Wortleitungen WLi, die Bitleitungen BLi und die Steuerleitungen Ci auf einem niedrigen Potential, beispielsweise Masse. Das heißt, die Potentialgeneratoren 1 sind nicht aktiviert. Zur Einleitung eines Lesezugriffs werden die Potentialgeneratoren 1 aktiviert und erzeugen auf den Steuerleitungen Ci das Lesepotential VDD, das einem hohen Versorgungspotential des integrierten Speichers entspricht. Anschließend wird über einen nicht dargestellten Wortleitungsdecoder eine der Wortleitungen WLi adressiert und vom niedrigen auf einen hohen Pegel gebracht. Hierdurch werden die mit dieser Wortleitung WLi verbundenen Speichertransistoren T leitend geschaltet. Durch das auf den Steuerleitungen Ci vorhandene Lesepotential VDD fließt über die selektierten Speichertransistoren T ein Drainstrom, der über die zugehörige Bitleitung BLi zur jeweiligen Stromerfassungseinheit 2 fließt. Zwischen dem Ausgang des Potentialgenerators 1 und der jeweiligen Stromerfassungseinheit 2 liegt eine positive Spannung an.

Je nachdem, ob eine logische Null oder eine logische Eins im Speichertransistor T gespeichert ist, weist sein ferroelektrisches Gatedielektrikum eine unterschiedliche Polarisation auf. Hierdurch ergeben sich unterschiedliche Einsatzspannungen für die beiden unterschiedlichen logischen Zustände. Die unterschiedlichen Einsatzspannungen haben eine unterschiedliche Leitfähigkeit der Speichertransistoren T bei jeweils aktivierter Wortleitung zur Folge. Handelt es sich um eine gespeicherte logische Eins, ist der sich einstellende Drainstrom größer, als wenn es sich um eine gespeicherte logische Null handelt. Im Extremfall fließt beim Auslesen einer logischen Null über den jeweiligen Speichertransistor überhaupt kein Drainstrom, das heißt sein Wert ist Null. Dies ist dann der Fall, wenn durch den zugehörigen Polarisationszustand des Gatedielektrikums die Einsatzspannung des Speichertransistors T soweit angehoben ist, daß sie durch das Potential auf der zugehörigen Wortleitung WLi nicht überschritten wird.

Figur 2 zeigt ein erstes Ausführungsbeispiel des erfindungsgemäßen integrierten Speichers. Bei diesem sind jeweils einer der Steuerleitungen Ci zwei der Bitleitungen BLi zugeordnet.

In Figur 2 wurde lediglich eine dieser Dreiergruppen, die durch eine zusammengehörende Steuerleitung und zwei Bitleitungen gebildet ist, dargestellt. Weitere gleichartige Gruppen schließen sich oben und unten an die in Figur 2 dargestellte Gruppe an.

In Figur 2 ist die Steuerleitung Ci wiederum mit dem Ausgang eines Potentialgenerators 1 verbunden. Beide Bitleitungen BL0, BL1 sind mit jeweils einer Stromerfassungseinheit 2 verbunden. Die Steuerleitung C0 ist mit beiden Bitleitungen BLi jeweils über eine Vielzahl von Speichertransistoren T verbunden. Dabei sind die steuerbaren Strecken der Speichertransistoren T parallel zu den Bitleitungen BLi und den Steuerleitungen Ci angeordnet. Jeweils benachbarte Speichertransistoren T weisen ein gemeinsames Source-/Draingebiet auf.

Bei einem Lesezugriff bringt der Potentialgenerator 1 die Steuerleitung C0 auf ein hohes Potential VDD. Außerdem wird eine der Wortleitungen WLi auf ein hohes Potential gebracht, so daß die mit dieser Wortleitung verbundenen Speichertransistoren T selektiert werden. Über diese Speichertransistoren T fließt jeweils ein Drainstrom von der Steuerleitung C0 zu jeder der beiden Bitleitungen BLi. Die Höhe dieses Drainstromes ist wiederum abhängig von im Speichertransistor T gespeicherten logischen Zustand. Durch die Stromerfassungseinheiten 2 erfolgt wiederum eine Auswertung des jeweiligen Drainstromes.

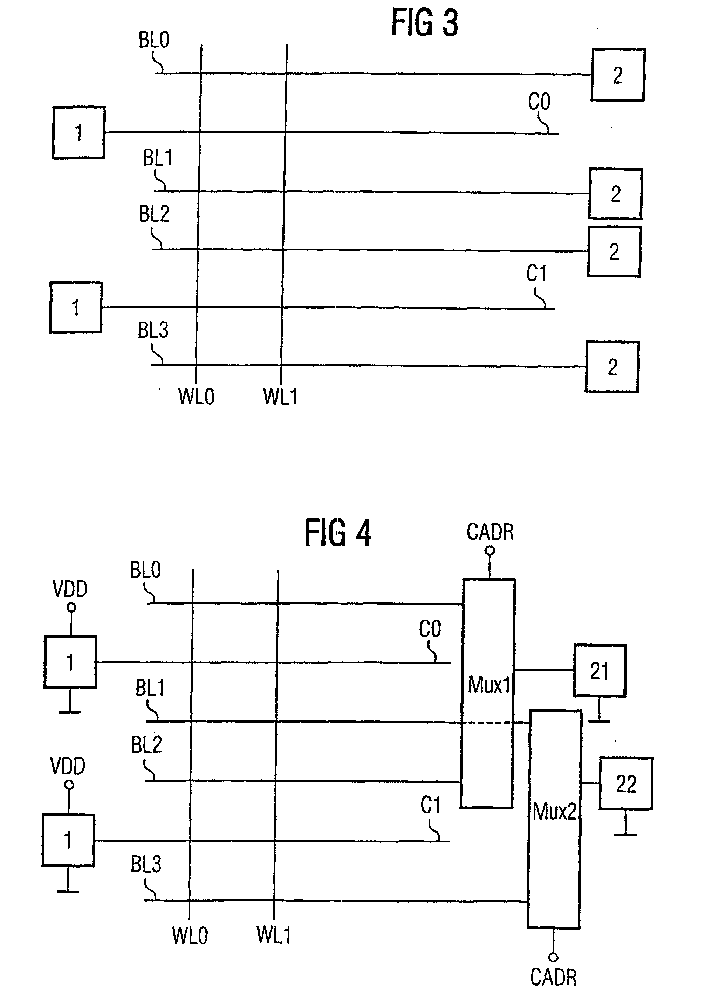

Figur 3 zeigt einen größeren Ausschnitt des in Figur 2 dargestellten Speichers, bei dem aus Gründen der Übersichtlichkeit lediglich die Bitleitungen BLi, die Steuerleitungen Ci und die Wortleitungen WLi ohne die Speichertransistoren T dargestellt wurden. Dargestellt sind zwei benachbarte Gruppen von jeweils zwei Bitleitungen BLi und einer Steuerleitung Ci von der in Figur 2 dargestellten Art. Gemäß Figur 3 können über die zwei Steuerleitungen Ci und die vier Bitleitungen BLi insgesamt vier Speicherzellen gleichzeitig ausgewertet werden, indem der Drainstrom ihrer Speichertransistoren den vier Stromerfassungseinheiten 2 zugeführt wird.

Figur 4 zeigt eine Abwandlung des in Figur 3 dargestellten Ausführungsbeispiels. Die Unterschiede bezüglich Figur 3 bestehen in der Zuordnung der Stromerfassungseinheiten zu den Bitleitungen BLi. In Figur 4 sind jeweils zwei der Bitleitungen einer Stromerfassungseinheit 21, 22 zugeordnet. Diese Zuordnung erfolgt mittels Multiplexern Mux1, Mux2, über die die beiden Bitleitungen mit der zugehörigen Stromerfassungseinheit 21, 22 verbunden sind. In Figur 4 sind die Bitleitungen BL0 und BL2 über den ersten Multiplexer Mux1 mit der ersten Stromerfassungseinheit 21 und die Bitleitungen BL1 und BL3 über den zweiten Multiplexer Mux2 mit der zweiten Stromerfassungseinheit 22 verbunden.

Bei einem Lesezugriff werden durch Aktivierung einer der Wortleitungen WLi zwar wiederum gleichzeitig vier Speicherzellen selektiert. Jeder Multiplexer Muxi verbindet jedoch nur eine der beiden mit ihm verbundenen Bitleitungen mit der zugehörigen Stromerfassungseinheit 21, 22.

Den Multiplexern Muxi werden Spaltenadressen CADR zugeführt, in deren Abhängigkeit sie eine der mit ihnen verbundenen Bitleitungen BLi mit der Stromerfassungseinheit 21, 22 verbinden. Bei diesem Ausführungsbeispiel verbinden die beiden Multiplexer beispielsweise bei Anliegen einer ersten Spaltenadresse CADR die Bitleitungen BL0 und BL1 mit den beiden Stromerfassungseinheiten 21, 22. Bei Anliegen einer zweiten Spaltenadresse verbinden sie die Bitleitungen BL2 und BL3 mit den Stromerfassungseinheiten. Auf diese Weise können zwar weniger gespeicherte Informationen gleichzeitig aus dem Speicher ausgelesen werden als beim Ausführungsbeispiel gemäß Figur 3. Dies ist aber kein Nachteil, wenn die Anzahl der externen Anschlüsse des Speichers, wie in der Regel üblich, ohnehin limitiert ist. Als Vorteil gegenüber Figur 3 weist der Speicher gemäß Figur 4 eine geringere Anzahl von Stromerfassungseinheiten 21, 22 auf.

Beim Ausführungsbeispiel in Figur 4 sind jeweils zwei der Bitleitung BLi über einen Multiplexer Muxi einer Stromerfassungseinheit 21, 22 zugeordnet. Es sind andere Ausführungsbeispiele möglich, bei denen eine beliebige Anzahl von Bitleitungen BLi jedem Multiplexer Muxi zugeführt wird.

## Patentansprüche

1. Integrierter Speicher
- mit Speicherzellen, die je einen ferroelektrischen Speichertransistor (T) aufweisen, dessen Steuerelektrode eine ferroelektrische Schicht enthält, die wenigstens zwei unterschiedliche Polarisationszustände annehmen kann,
- mit Wortleitungen (WLi), die im wesentlichen in einer ersten Richtung verlaufen,
- mit Bitleitungen (BLi), die im wesentlichen in einer zweiten Richtung, die senkrecht zur ersten Richtung ist, verlaufen, und
- mit Steuerleitungen (Ci),
- bei dem eine steuerbare Strecke jedes Speichertransistors (T) eine der Bitleitungen (BLi) mit einer der Steuerleitungen (Ci) verbindet,
- bei dem die Steuerelektrode jedes Speichertransistors (T) mit einer der Wortleitungen (WLi) verbunden ist, und
- bei dem die Steuerleitungen (Ci) im wesentlichen in der zweiten Richtung verlaufen,
**dadurch gekennzeichnet, daß**
- jeweils eine der Steuerleitungen (Ci) zwischen je zweien der Bitleitungen (BLi) angeordnet ist, mit denen sie jeweils über die steuerbaren Strecken mehrerer der Speichertransistoren (T) verbunden ist,
- die steuerbaren Strecken der Speichertransistoren (T) parallel zu den Bitleitungen (BLi) und Steuerleitungen (Ci) angeordnet sind, und
- diejenigen Speichertransistoren (T), die mit derselben Bitleitung (BLi) verbunden sind, jeweils gemeinsame Source-/Draingebiete auf weisen.

2. Integrierter Speicher nach Anspruch 1,
**gekennzeichnet durch**
Stromerfassungseinheiten (2), die mit je einer der Bitleitungen (BLi) verbunden sind, zur Erfassung eines während eines
Lesezugriffs zwischen den Steuerleitungen (Ci) und den Bitleitungen (BLi) über die Speichertransistoren (T) fließenden Stromes.

3. Integrierter Speicher nach Anspruch 1 oder 2,
**gekennzeichnet durch**
zwei Multiplexer (Muxi) und zwei Stromerfassungseinheiten (21, 22), wobei:
- zwei der Bitleitungen (BLi), die über ihre Speichertransistoren (T) mit zwei unterschiedlichen Steuerleitungen (Ci) verbunden sind, über den ersten Multiplexer (Muxi) mit der ersten Stromerfassungseinheit (21) verbunden sind,
- zwei andere der Bitleitungen (BLi), die über ihre Speichertransistoren (T) mit denselben beiden Steuerleitungen (Ci) verbunden sind wie die ersten beiden Bitleitungen, über den zweiten Multiplexer (Mux2) mit der zweiten Stromerfassungseinheit (22) verbunden sind, und
- die Multiplexer (Muxi) zwei Betriebszustände haben, in denen sie jeweils eine der mit ihnen verbundenen Bitleitungen (BLi) mit der jeweiligen Stromerfassungseinheit (21, 22) verbinden.

## Claims

1. Integrated memory
- with memory cells which each have a ferroelectric memory transistor (T), the control electrode of which contains a ferroelectric layer, which can assume at least two different polarization states,
- with word lines (WLi), which run essentially in a first direction,
- with bit lines (BLi), which run essentially in a second direction, which is perpendicular to the first direction, and
- with control lines (Ci),
- in which a controllable path of each memory transistor (T) connects one of the bit lines (BLi) to one of the control lines (Ci),
- in which the control electrode of each memory transistor (T) is connected to one of the word lines (WLi), and
- in which the control lines (Ci) run essentially in the second direction,
**characterized in that**
- one of the control lines (Ci) in each case is arranged between pairs of the bit lines (BLi), to which it is respectively connected via the controllable paths of a number of the memory transistors (T),
- the controllable paths of the memory transistors (T) are arranged parallel to the bit lines (BLi) and control lines (Ci), and
- those memory transistors (T) which are connected to the same bit line (BLi) respectively have common source-drain regions.

2. Integrated memory according to Claim 1, **characterized by** current detection units (2), which are connected to one of the bit lines (BLi) each, for detecting a current flowing between the control lines (Ci) and the bit lines (BLi) via the memory transistors (T) during a read access.

3. Integrated memory according to Claim 1 or 2, **characterized by** two multiplexers (Muxi) and two current detection units (21, 22), with:
- two of the bit lines (BLi) which are connected via their memory transistors (T) to two different control lines (Ci) being connected via the first multiplexer (Mux1) to the first current detection unit (21),
- another two of the bit lines (BLi) which are connected via their memory transistors (T) to the same two control lines (Ci) as the first two bit lines being connected via the second multiplexer (Mux2) to the second current detection unit (22), and
- the multiplexers (Muxi) having two operating states, in which they respectively connect one of the bit lines (BLi) connected to them to the respective current detection unit (21, 22).

## Revendications

1. Mémoire intégrée
- comprenant des cellules de mémoire qui ont chacune un transistor (T) ferroélectrique de mémoire dont l'électrode de commande comporte une couche ferroélectrique qui peut prendre au moins deux états différents de polarisation,
- comprenant des lignes (WLi) de mots qui s'étendent sensiblement dans une première direction,
- comprenant des lignes (BLi) de bits qui s'étendent sensiblement dans une deuxième direction qui est perpendiculaire à la première direction, et
- comprenant des lignes (Ci) de commande,
- dans laquelle une section qui peut être commandée de chaque transistor (T) de mémoire relie l'une des lignes (BLi) de bits à l'une des lignes (Ci) de commande,
- dans laquelle l'électrode de commande de chaque transistor (T) de mémoire est reliée à l'une des lignes (WLi) de mots, et
- dans laquelle les lignes (Ci) de commande s'étendent sensiblement dans la deuxième direction,
**caractérisée en ce que**
- respectivement l'une des lignes (Ci) de commande est disposée entre respectivement deux des lignes (BLi) de bits avec lesquelles elle est reliée respectivement par les sections qui peuvent être commandées de plusieurs des transistors (T) de mémoire,
- les sections qui peuvent être commandées des transistors (T) de mémoire sont disposées parallèlement aux lignes (BLi) de bits et aux lignes (Ci) de commande, et
- les transistors (T) de mémoire qui sont reliés à la même ligne (BLi) de bits ont respectivement des zones communes de sources/drains.

2. Mémoire intégrée suivant la revendication 1, **caractérisée par** des unités (2) de détection du courant qui sont reliées respectivement à l'une des lignes (BLi) de bits et qui sont destinées à détecter un courant passant pendant un accès en lecture par les transistors (T) de mémoire entre les lignes (Ci) de commande et les lignes (BLi) de bits.

3. Mémoire intégrée suivant la revendication 1 ou 2, **caractérisée par** deux multiplexeurs (Muxi) et deux unités (21, 22) de détection du courant, dans laquelle :
- deux des lignes (BLi) de bits, qui sont reliées par leurs transistors (T) de mémoire à deux lignes (Ci) différentes de commande, sont reliées par le premier multiplexeur (Mux1) à la première unité (21) de détection du courant,
- deux autres des lignes (BLi) de bits, qui sont reliées par leurs transistors (T) de mémoire aux mêmes deux lignes (Ci) de commande que les deux premières lignes de bits, sont reliées par le deuxième multiplexeur (Mux2) à la deuxième unité (22) de détection du courant, et
- les multiplexeurs (Muxi) ont deux états de fonctionnement dans lesquels ils relient respectivement l'une des lignes (BLi) de bits qui leur sont reliées à l'unité (21, 22) respective de détection du courant.
